Europäisches Patentamt

European Patent Office

Office européen des brevets

(19)

(11) Veröffentlichungsnummer: **0 131 952**
**A2**

(12) # EUROPÄISCHE PATENTANMELDUNG

(21) Anmeldenummer: **84108362.9**

(22) Anmeldetag: **16.07.84**

(51) Int. Cl.⁴: **H 03 K 19/094**

(30) Priorität: **18.07.83 DE 3325873**

(43) Veröffentlichungstag der Anmeldung:
**23.01.85 Patentblatt 85/4**

(84) Benannte Vertragsstaaten:
**AT BE CH DE FR GB IT LI NL**

(71) Anmelder: **Siemens Aktiengesellschaft**
**Berlin und München Wittelsbacherplatz 2**
**D-8000 München 2(DE)**

(72) Erfinder: **Wiedeburg, Klaus Hanno, Dr. Ing.**
**Veilchenstrasse 7**
**D-8039 Puchheim(DE)**

(54) **Logik-Schaltungsanordnung.**

(57) Zur Verbindung einer in BFL-Technik realisierten Logik-Schaltung mit einer in ECL-Technik realisierten Logik-Schaltung ist der Ausgang der BFL-Logik-Schaltung über einen BFL-Negator-Zweig mit dem einen Eingang und direkt mit dem anderen Eingang einer MESFET-Push-Pull-Stufe verbunden ist, die dem Eingang der ECL-Logik-Schaltung vorgeschaltet ist.

FIG 1

EP 0 131 952 A2

0131952

Unser Zeichen

VPA **83** P 1 4 9 1 E

SIEMENS AKTIENGESELLSCHAFT
Berlin und München

## Logik-Schaltungsanordnung

Ausgehend von in der konventionellen Digitaltechnik
gebräuchlichen Schaltungskonzepten wurden für integrierte Digitalschaltungen verschiedene Schaltungstechniken entwickelt, die den besonderen Eigenschaften
und Möglichkeiten integrierter Schaltungen in besonderem
Maße gerecht werden; eine dieser Schaltungstechniken ist
die bereits seit längerem eingesetzte ECL-Technik
(Hartmut, Duck, Jenik: "Aufbau und Anwendung integrierter
Halbleiterschaltungen", Siemens-Sonderdruck, Best.-Nr.
2-6300-262).

Neuere Entwicklungen der Halbleiter-Technik haben zu integrierten Logik-Schaltungen mit GaAs-Metall-Halbleiter-
Feldeffekttransistoren, sog. MESFETs, geführt, wobei man
heute im Prinzip vier GaAs-MESFET-Schaltungstechniken
unterscheidet (IEEE Journal of Solid-State Circuits
Vol. SC-17, No. 3, June 1982, S.569...584, 573):
    1) die sog. BFL(Buffered FET Logic)-Technik,
    2) die sog. SDFL(Schottky Diode FET Logic)-Technik,
    3) die sog. DCFL(Direct Coupled FET Logic)-Technik, und
    4) die sog. LPFL(Low Pinchoff-Voltage FET Logic)-Technik.

Die letzteren beiden GaAs-MESFET-Schaltungstechniken sehen (im Prinzip)
Anreicherungs-(Enhancement-)Transistoren vor, d.h. ohne
Gatespannung nichtleitende Transistoren, bei denen die
Kanalbildung durch eine Gatespannung bewirkt wird;
die ersteren beiden GaAs-MESFET-Schaltungstechniken sehen
Verarmungs-(Depletion-)Transistoren vor, d.h. aufgrund entsprechender Dotierung der Kanalzone ohne Gatespannung
leitende Transistoren, die durch eine Gatespannung gesperrt
28.6.83 /Spr 1 Kel

0131952
83 P 1491 E

werden. Verarmungstyp-Logikschaltungen, die eine zusätzliche Speisespannung zur Erzeugung der erforderlichen Sperrspannung benötigen, zeigen im Prinzip einen
zweistufigen Aufbau ihrer Verknüpfungsglieder ; so besteht jedes BFL-Verknüpfungsglied aus dem eigentlichen
Logik-Zweig und einem nachfolgenden Buffer-Zweig.
Jede Schaltungstechnik hat gewisse Vorteile; so erreicht man mit der BFL-Technik sehr hohe Schaltgeschwindigkeiten bei allerdings relativ hohen Verlustleistungen.

Zur Verringerung der Verlustleistung und/oder aufgrund
der noch relativ geringen Integrationsdichte hat es
sich als wünschenswert erwiesen, BFL-Logik-Schaltungen
mit  ECL(Emitter Coupled Logic)-Bausteinen ungeachtet
der bei einer BFL-Logik-Schaltung einerseits und einer
ECL-Logik-Schaltung andererseits unterschiedlichen
Signalpegel und Pegelhübe kombinieren zu können, und
die Erfindung zeigt hierzu einen Weg.

Die Erfindung betrifft eine Logik-Schaltungsanordnung
mit einer in BFL-Technik realisierten, ein oder mehrere
durch jeweils einen BFL-Logik-Zweig und einen nachfolgenden BFL-Buffer-Zweig gebildete, BFL-Verknüpfungsglieder aufweisenden GaAs-MESFET-
Logik-Schaltung; diese Schaltungsanordnung ist erfindungsgemäß dadurch gekennzeichnet, daß zur Verbindung
der BFL-Logik-Schaltung mit einer in ECL-Technik realisierten Logik-Schaltung ein durch den Ausgang des Buffer-Zweigs eines BFL-Verknüpfungsgliedes gebildeter
Ausgang der übrigen BFL-Logik-Schaltung über einen
BFL-Logik-Zweig, insbesondere einen BFL-Negator-Zweig,
mit dem Eingang in den einen Arm und direkt mit einem
entsprechenden Verknüpfungseingang in den anderen Arm
einer MESFET-Push-Pull-Stufe verbunden ist, die dem Eingang der ECL-Logik-Schaltung vorgeschaltet ist.
Die Erfindung bringt den Vorteil mit sich, einen direkten
Übergang von in BFL-Technik gehaltenen Schaltungsteilen
zu in ECL-Technik gehaltenen Schaltungsteilen vornehmen zu können, wobei durch entsprechende Wahl
der Kanalweiten sowohl z.B. durch Gehäuseanschlüsse
bedingte große Kapazitäten umgeladen als auch die für
die ECL-Technik erforderlichen Eingangsströme geliefert
werden können.

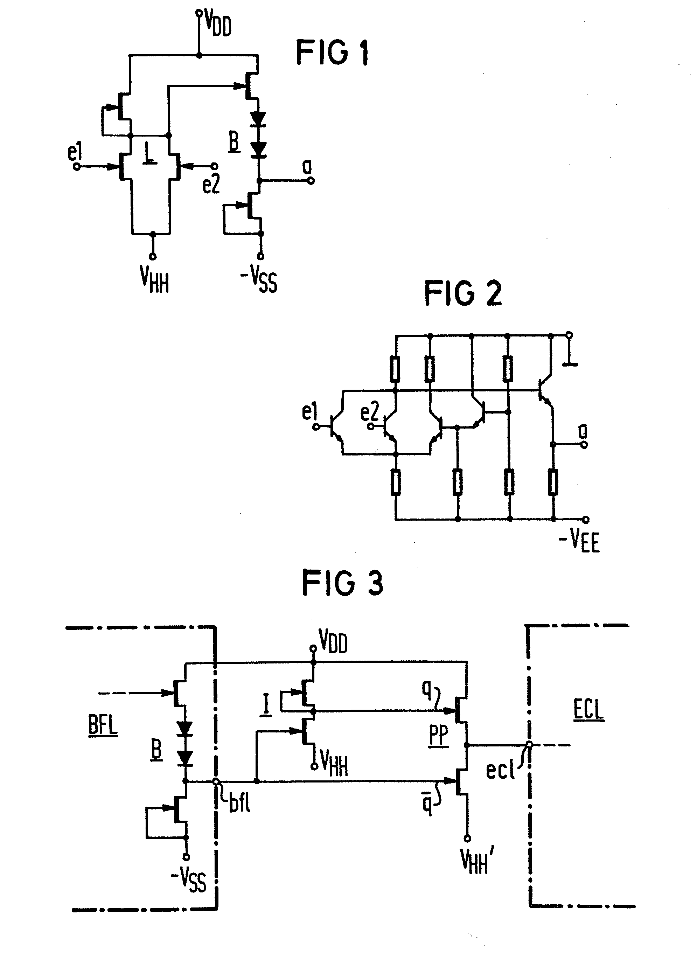

Anhand der Zeichnungen sei die Erfindung noch näher
erläutert. Dabei verdeutlicht
Fig.1 den prinzipiellen Aufbau eines in BFL-Technik
realisierten Verknüpfungsgliedes;
Fig.2 läßt den prinzipiellen Aufbau eines in ECL-Technik
realisierten Verknüpfungsgliedes erkennen.
Fig.3 zeigt ein Ausführungsbeispiel einer Logik-Schaltungsanordnung gemäß der Erfindung; ein anderes Ausführungsbeispiel zeigt Fig. 4.
Die Zeichnung Fig.1 zeigt zur Verdeutlichung der bekannten
BLF-Technik ein in dieser Technik ausgeführtes NOR-Glied
für zwei Eingangsvariable. Dieses NOR-Glied besteht aus
zwei Zweigen, dem mit zwei an ihren Steuerelektroden jeweils von einer Eingangsvariablen beaufschlagten, mit
ihren Hauptelektroden einander parallel geschalteten
MESFET-Eingangstransistoren und einem gemeinsamen
MESFET-Lasttransistor aufgebauten eigentlichen Logik-
Zweig und dem nachfolgenden, durch die Serienschaltung
eines MESFET-Lasttransistors, zweier Dioden und eines
vom Logik-Zweig L gesteuerten weiteren, als Source-Folger
geschalteten MESFET-Transistors gebildeten Buffer-Zweig B.
Der Buffer-Zweig (Treiberstufe) B liegt dabei zwischen
einer Source-Speisespannung $-V_{SS}$ und einer Drain-Speisespannung $V_{DD}$, an der auch der Logik-Zweig L liegt;
die Source-Elektroden der beiden Eingangstransistoren
des Logik-Zweiges L liegen an einer Hilfsspannung $V_{HH}$,
die auch durch Massepotential gegeben sein kann.
Nur wenn an beiden Eingängen e1 und e2 des NOR-Gliedes gemäß Fig.1 eine dem Wert O der Schaltvariablen entsprechende Sperrspannung (Low-Pegel) anliegt, ist der
vom Logik-Zweig L gesteuerte Transistor des Buffer-Zweiges
B so gut leitend, (daß) am Ausgang a des NOR-Gliedes gemäß
Fig.1 die dem Wert 1 der Schaltvariablen entsprechende
Ausgangsspannung (High-Pegel) auftritt.

Die Zeichnung Fig.2 zeigt demgegenüber ein in der
ebenfalls bekannten ECL-Technik ausgeführtes NOR-Glied
für zwei Eingangsvariable. Dieses NOR-Glied weist einen
emittergekoppelten Differenzverstärker auf, dessen einer
Zweig zwei von den zwei Eingangsvariablen beaufschlagte
OR-Verknüpfungs-Transistoren enthält und dessen Umschlagspannung durch die an die Basiselektrode des im anderen
Zweig liegenden Transistors von einem Spannungsteiler
her über einen Emitterfolger mit kleinem Innenwiderstand
angelegte Referenzspannung bestimmt wird; die an den
Kollektoren der Verknüpfungs-Transistoren auftretenden Signalpegel werden durch einen Emitterfolger wieder auf
das Niveau der Eingangssignalpegel zurückgeschoben.

Wie man erkennt, tritt am Ausgang a des NOR-Gliedes
gemäß Fig.2 eine dem Wert 1 der Schaltvariablen entsprechende Ausgangsspannung (High-Pegel) nur dann auf,
wenn an beiden Eingängen e1 und e2 eine dem Wert O
der Schaltvariablen entsprechende Sperrspannung (Low-Pegel)
anliegt.

Nachdem Low- bzw. High-Pegel einer BLF-Logik-Schaltung
einerseits und einer ECL-Logik-Schaltung andererseits
nicht miteinander übereinstimmen, kann eine ECL-Logik-
Schaltung nicht unmittelbar an eine BLF-Logik-Schaltung
angeschlossen werden. Wie dennoch eine Verbindung einer
in ECL-Technik realisierten Logik-Schaltung mit einer in
BFL-Technik realisierten, eine oder mehrere durch jeweils
einen BFL-Logik-Zweig und einen nachfolgenden BFL-Buffer-
Zweig gebildete BFL-Verknüpfungsschaltungen aufweisenden

0131952
83 P 1491 E

GaAs-MESFET-Logik-Schaltung realisiert werden kann, zeigt Fig.3.

Gemäß Fig.3 ist ein durch einen BFL-Negator I gebildeter BFL-Logik-Zweig dem durch den Ausgang des Buffer-Zweigs B (vgl. Fig.1) eines BFL-Verknüpfungsgliedes gebildeten Ausgang bfl der übrigen, in Fig.3 nicht näher dargestellten BFL-Logik-Schaltung EFL nachgeschaltet. Der Ausgang bfl der BFL-Logik-Schaltung BFL ist über diesen BFL-Logik-Zweig I mit dem einen Eingang q und außerdem direkt mit dem anderen Eingang $\bar{q}$ einer im Gegentakt betriebenen, zwischen der Drain-Speisespannung $V_{DD}$ und einer Hilfsspannung $V_{HH}'$ liegenden GaAs-MESFET-Treiberstufe ("Push-Pull"-Stufe) PP verbunden, die dem Eingang ecl der in Fig.3 wiederum nicht näher dargestellten ECL-Logik-Schaltung ECL vorgeschaltet ist. Am Ausgang der Gegentaktstufe PP, bei der bei leitendem unteren Transistor der obere Transistor nicht exakt gesperrt und somit der Ausgangspegel noch variierbar ist, treten dann bei entsprechend gewählter Hilfsspannung $V_{HH}'$ und entsprechender MESFET-Kanalweite gerade die für die ECL-Technik charakteristischen Signalpegel auf, wobei die Stromergiebigkeit und Schaltgeschwindigkeit am Ausgang der Gegentaktstufe PP durch Verändern der Kanalweiten beider Transistoren bei gleichbleibendem Verhältnis ihrer Kanalweiten zueinander an die ECL-Schaltung ECL angepaßt werden kann, so daß die Push-Pull-Stufe PP zugleich als Treiberstufe genutzt werden kann.

BFL-Logik-Schaltung und ECL-Logik-Schaltung können nun miteinander zusammenarbeiten, was hier indessen nicht weiter betrachtet zu werden braucht, da dies zum Verständnis der Erfindung nicht mehr erforderlich ist.

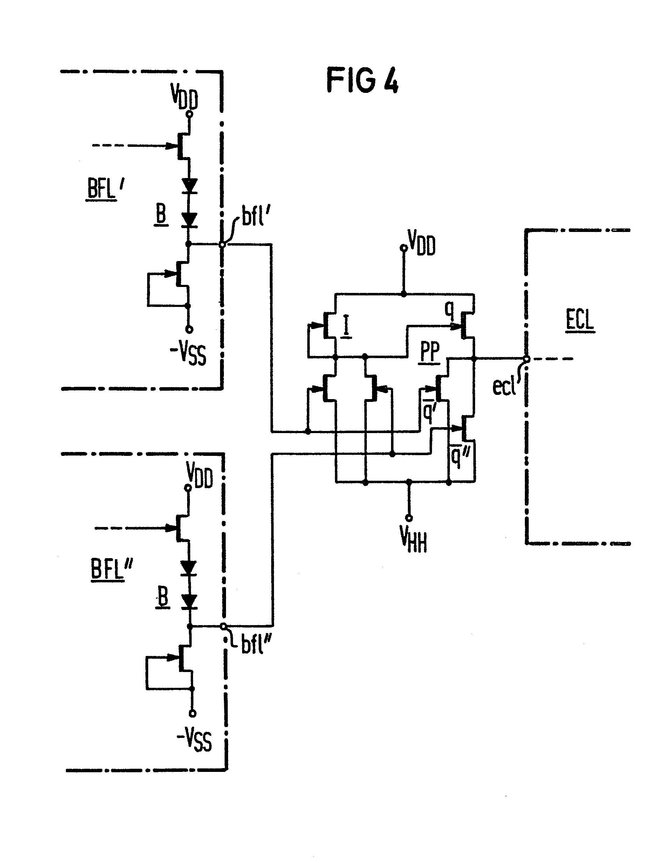

Es sei noch besonders bemerkt, daß der dem Ausgangs-Buffer-Zweig B der BFL-Logik-Schaltung nachgeschaltete, gemäß Fig.3 durch den BFL-Negator I gebildete BFL-Logik-Zweig in Abweichung von der in Fig.3 gegebenen Darstellung auch durch einen BFL-Logik-Zweig für mehrere, im Rahmen einer BFL-Logik-Schaltung ohnehin zu verknüpfende Eingangsvariable gebildet sein kann; die Push-Pull-Stufe weist dann in entsprechender Weise anstelle des einzigen genannten anderen Eingangs $\bar{q}$ (in FIG 3) mehrere derartige andere Eingänge zu der zwischen der Hilfsspeisespannung $V_{HH}$ und dem Ausgang pp der Push-Pull-Stufe PP liegenden, dann durch eine Mehrzahl von MESFETransistoren gebildeten entsprechenden Verknüpfungsschaltung für die genannten mehreren Eingangsvariablen auf. Ein Ausführungsbeispiel für eine NOR-Verknüpfung zweier solcher Eingangsvariabler bfl' und bfl" zeigt FIG 4; hier wird sowohl im BFL-Logik-Zweig I als auch in der Push-Pull-Stufe PP jeweils durch eine Parallelschaltung zweier MESFETransistoren eine NOR-Verknüpfung bewirkt. In entsprechender Weise sind beispielsweise bei einer NAND-Verknüpfung anstelle der in FIG 4 vorgesehenen Parallelschaltung von MESFETransistoren entsprechende Serienschaltungen vorzusehen, was hier indessen nicht weiter dargestellt zu werden braucht.

0131952
83 P 1491 E

Patentansprüche

1. Logik-Schaltungsanordnung mit einer in BFL-Technik realisierten, ein oder mehrere durch jeweils einen BFL-Logik-Zweig und einen nachfolgenden BFL-Buffer-Zweig gebildete BFL-Verknüpfungsglieder aufweisenden GaAs-MESFET-Logik-Schaltung, d a d u r c h   g e - k e n n z e i c h n e t , daß zur Verbindung der BFL-Logik-Schaltung (BFL) mit einer in ECL-Technik realisierten Logik-Schaltung (ECL) ein durch den Ausgang des Buffer-Zweigs (B) eines BFL-Verknüpfungsgliedes gebildeter Ausgang (bfl) der übrigen BFL-Logik-Schaltung (BFL) über einen BFL-Logik-Zweig (I) mit dem Eingang (q) in den einen Arm und direkt mit einem entsprechenden Verknüpfungseingang ($\overline{q}$) in den anderen Arm einer MESFET-Push-Pull-Stufe (PP) verbunden ist, die dem Eingang (ecl) der ECL-Logik-Schaltung (ECL) vorgeschaltet ist.

2. Logik-Schaltungsanordnung nach Anspruch 1, d a - d u r c h   g e k e n n z e i c h n e t , daß der Ausgang (bfl) der übrigen BFL-Logik-Schaltung (BFL) über einen BFL-Negator-Zweig (I) mit dem einen Eingang (q) und direkt mit den anderen Eingang ($\overline{q}$) der MESFET-Push-Pull-Stufe (PP) verbunden ist.

FIG 1

FIG 2

FIG 3

# FIG 4